(19) Europäisches Patentamt
European Patent Office
Office européen des brevets

(11) Veröffentlichungsnummer: **0 007 468**
**B1**

(12) # EUROPÄISCHE PATENTSCHRIFT

(45) Veröffentlichungstag der Patentschrift: **07.04.82**

(51) Int. Cl.³: **C 08 F 2/50,** C 08 L 33/08, G 03 C 1/68 //C09D3/80

(21) Anmeldenummer: **79102215.5**

(22) Anmeldetag: **02.07.79**

(54) **Photohärtbare Zusammensetzungen.**

(30) Priorität: **13.07.78 CH 7622/78**

(43) Veröffentlichungstag der Anmeldung: **06.02.80 Patentblatt 80/3**

(45) Bekanntmachung des Hinweises auf die Patenterteilung: **07.04.82 Patentblatt 82/14**

(84) Benannte Vertragsstaaten: **BE CH DE FR GB IT NL**

(56) Entgegenhaltungen:
**DE-A-2 719 131**
**FR-A-2 273 042**
**US-A-4 047 034**

(73) Patentinhaber: **CIBA-GEIGY AG**
**Patentabteilung Postfach**
**CH-4002 Basel (CH)**

(72) Erfinder: **Berner, Godwin, Dr.**
**Oetlingerstrasse 2**
**CH-4057 Basel (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**EP 0 007 468 B1**

# Photohärtbare Zusammensetzungen

Die Erfindung betrifft photohärtbare Zusammensetzungen aus einer oder mehreren photohärtbaren, äthylenisch ungesättigten Verbindungen, einem Photoinitiator und einem Lichtschutzmittel, das gegebenenfalls noch sonstige übliche Additive enthalten kann.

Es ist bekannt, dass man die Photopolymerisation äthylenisch ungesättigter Verbindungen durch den Zusatz von Photoinitiatoren erheblich beschleunigen kann. Dies ist für die technische Anwendung von Photopolymerisationen, beispielsweise für Lacke, Beschichtungen, Formmassen oder Druckfarben von entscheidender Bedeutung. Es sind verschiedene Klassen von organischen Verbindungen als Photohärter bekannt geworden, beispielsweise Derivate von Benzophenon, von Benzoin, von Acetophenon oder von Benzil. In der DE—OS 2 722 264 sowie in der EP—A 0 003 002 wurden aromatischaliphatische Ketone, die im aliphatischen Rest durch Hydroxyl-, Alkoxy-, Silyloxy- oder Aminogruppen substituiert sind, als Photoinitiatoren vorgeschlagen.

Für bestimmte Anwendungen der Photopolymerisation besteht ein Bedürfnis, die ausgehärteten Massen gegen Vergilbung oder Abbau durch Lichteinwirkung zu schützen. Dies ist vor allem bei der Anwendung für unpigmentierte Ueberzüge und Formmassen der Fall wie z.B. bei Klarlacken, Beschichtungen für Holz oder Holzfaserplatten, Beschichtungen von Kunststoffen oder Beschichtungen von bedrucktem Papier- und Pappartikeln.

Die naheliegende Lösung des Problems wäre der Zusatz von Lichtschutzmitteln, wie sie zum Stabilisieren von Kunststoffen und Lacken üblich sind. Solche Lösungen wurden bereits vorgeschlagen beispielsweise in der DE—OS 1 694 253 die Kombination von Benzoinäthern als Photoinitiatoren mit UV-Absorbern als Lichtschutzmittel. Diese UV-Absorber haben den Nachteil, auf Grund ihrer UV-Absorption die Photopolymerisation zu verzögern. Die durch Zusatz eines Photoinitiators erzielte Beschleunigung der Photopolymerisation wird also durch den verwendeten UV-Absorber teilweise wieder aufgehoben, vor allem wenn der UV-Absorber in einer Menge von über 0,3% verwendet wird.

Ein Fortschritt lässt sich erzielen, wenn man anstelle der UV-Absorber Lichtschutzmittel aus der Klasse der Polyalkylpiperidinderivate verwendet. Diese verzögern die Härtungsgeschwindigkeit nicht, selbst wenn sie in Mengen von 1—2% verwendet werden. Die Piperidinderivate haben jedoch den Nachteil, dass sie mit den meisten Photoinitiatoren nach der UV-Härtung eine Gelbfärbung der polymerisierten Masse bewirken.

Es wurde nun überraschend gefunden, dass eine solche Gelbfärbung durch Piperidin-Lichtschutzmittel in wesentlich geringerem Ausmass eintritt, wenn man als Photoinitiatoren ganz bestimmte Verbindungen verwendet. Gegenstand der Erfindung sind daher photohärtbare Zusammensetzungen, bestehend aus

a) einer oder mehreren äthylenisch ungesättigten, photohärtbaren Verbindungen,

b) 0,1 bis 10 Gew.-% mindestens eines Photoinitiators der Formel I oder II,

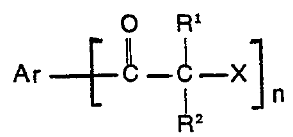
I

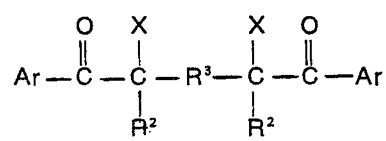
II

worin

n 1 oder 2 ist,

Ar, wenn n=1 ist, unsubstituiertes oder durch einen oder mehrere des Reste F, Cl, Br, $C_1$—$C_{12}$ Alkyl, -OAlk, Phenyl, -OPhenyl, —SAlk, —$SCH_2CH_2OH$ oder -SPhenyl, substituiertes Phenyl, Indanyl oder Tetrahydronaphthyl darstellt und Alk einen Niederalkylrest mit 1—4 C-Atomen bedeutet und wenn n=2 ist, $C_6$—$C_{12}$ Arylen oder eine Gruppe -Phenylen-T-Phenylen- bedeutet, worin T —O—, —S—, —$CH_2$— oder —$CH_2CH_2$— darstellt,

X eine der Gruppen —$NR^4R^5$, —$OR^6$ oder —$OSiR^7(R^8)_2$ darstellt,

$R^1$ unsubstituiertes oder durch —OH, OAlk, $C_2$—$C_8$ Acyloxy, —$NR^4R^5$, —COOAlk oder —CN substituiertes $C_1$—$C_8$ Alkyl, $C_3$—$C_4$ Alkenyl, $C_5$—$C_6$ Cycloalkyl oder $C_7$—$C_9$ Phenylalkyl bedeutet,

$R^2$ eine der für $R^1$ gegebenen Bedeutungen hat oder zusammen mit $R^1$ $C_2$—$C_8$ Alkylen oder $C_3$—$C_9$ Oxa- oder Azaalkylen bedeutet,

$R^3$ eine direkte Bindung, $C_1$—$C_6$ Alkylen, $C_2$—$C_6$ Oxaalkylen, $C_2$—$C_6$ Thia-, S-Oxothia- oder S-Dioxothiaalkylen, Phenylen, Diphenylen oder eine Gruppe -Phenylen-T-Phenylen bedeutet oder zusammen mit den beiden Substituenten $R^2$ und den beiden C-Atomen, an die diese Substituenten gebunden sind, einen Cyclopentan-, Cyclohexen-, Endomethylencyclohexan oder Cyclohexanring bildet,

$R^4$ $C_1$—$C_{12}$ Alkyl oder durch —OH oder OAlk substituiertes $C_2$—$C_4$ Alkyl bedeutet,

$R^5$ $C_1$—$C_{12}$ Alkyl oder durch OH oder OAlk substituiertes $C_2$—$C_4$ Alkyl, bedeutet oder zusammen mit $R^4$ $C_4$—$C_5$ Alkylen bedeutet, das durch —O— oder —$NR^9$— unterbrochen sein kann,

$R^6$ Wasserstoff, $C_1$—$C_{12}$ Alkyl, durch Cl, Br, OH, OAlk, SAlk, $C_2$—$C_8$ Acyloxy, —COOAlk, —CONHAlk, —$CON(Alk)_2$ oder CN substituiertes $C_1$—$C_8$ Alkyl, $C_3$—$C_5$ Alkenyl, Cyclohexyl, Benzyl, unsubstituiertes oder durch Cl oder Alk substituiertes Phenyl oder 2-Tetrahydropyranyl bedeutet,

$R^7$ und $R^8$ gleich oder verschieden sind und $C_1$—$C_4$ Alkyl oder Phenyl bedeuten, und

$R^9$ $C_1$—$C_4$ Alkyl, —$CH_2CH_2CN$ oder —$CH_2CH_2COOAlk$ bedeuten,

c) 0,02 bis 5 Gew.% eines Lichtschutzmittels aus der Klasse der Polyalkylpiperidinderivate enthaltend einen Rest der Formel

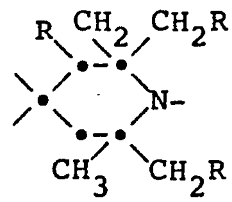

worin

R Wasserstoff oder Methyl ist, und

d) gegebenenfalls einem oder mehreren sonstigen in der Kunststofftechnologie üblichen Additiven, insbesondere solche Zusammensetzungen, worin die Komponente (b) ein Photohärter der Formel I oder II ist, worin X —$OR^6$ oder —$OSiR^7$ $(R^8)_2$ darstellen.

Erfindungsgemäss verwendbare äthylenisch ungesättigte Verbindungen sind die dem Fachmann bekannten photohärtbaren Monomeren, Oligomeren oder Polymeren. Solche Monomere mit einer oder mehreren photopolymerisierbaren Doppelbindungen sind beispielsweise die Ester von Acryl- oder Methacrylsäure, z.B. Methyl-, Aethyl-, n- oder tert.

Butyl-, Isooctyl-, 2-Aethylhexyl-, Phenyl-, Benzyl-, 2-Hydroxyäthyl- oder 2-Hydroxypropylacrylat, Methyl- oder Aethylmethacrylat, Aethylen-diacrylat, Neopentyl-diacrylat, Trimethylolpropantrisacrylat, Pentaerythrit-tetraacrylat oder Pentaerythrit-trisacrylat; Acrylnitril, Methacrylnitril, Acrylamid, Methacrylamid, N-substituierte (Meth)-acrylamide; Vinylester wie z.B. Vinyl-acetat, -propionat, -acrylat oder -succinat; sonstige Vinylverbindungen wie Vinyläther, Styrol, Alkylstyrole, Halogenstyrole, Divinylbenzol, Vinylnaphthalin, N-Vinylpyrrolidon, Vinylchlorid oder Vinylidenchlorid; Allylverbindungen wie Diallylphthalat, Diallylmaleat, Triallylisocyanurat, Triallylphosphat oder Aethylenglycol-diallyläther und die Mischungen von solchen ungesättigten Monomeren.

Photopolymerisierbare ungesättigte Oligomere oder Polymere sind beispielsweise thermoplastische Harze, die ungesättigte Gruppen wie Fumarsäureester, Allylgruppen oder Acrylat- oder Methacrylatgruppen enthalten, ungesättigte Polyester, ungesättigte Acrylharze und Isocyanat- oder Epoxid-modifizierte Acrylatoligomere sowie Polyester- und Polyätheracrylatoligomere. Photopolymerisierbare Polymere werden vorzugsweise im Gemisch mit photopolymerisierbaren Monomeren verwendet. Bevorzugt als Komponente (a) werden Acryl- und Methacrylsäurederivate und deren Mischungen, besonders bevorzugt werden Polyurethanacrylat und deren Gemische mit anderen Acryl- oder Methacrylsäurederivaten. Solche Polyurethanacrylate werden aus Polyolen oder Polyätherdiolen durch Umsetzung mit überschüssigem Diisocyanat und anschliessende Umsetzung mit Hydroxyalkylacrylaten hergestellt.

Die erfindungsgemäss als Komponente (b) verwendeten Photoinitiatoren der Formel I oder II sind bekannte Verbindungen. In der DE—OS 2 722 264 und in der EP—A 0 003 002 werden solche Verbindungen, ihre Herstellung und ihre Verwendung als Photoinitiatoren beschrieben.

Beispiele für den Rest Ar in Formel I oder II sind Phenyl, Tolyl, Xylyl, tert.-Butylphenyl, Isopropylphenyl, Methoxy-, Aethoxy- oder Isopropoxyphenyl, Diphenylyl, Phenoxyphenyl, Methylthiophenyl, tert.-Butylthiophenyl, Phenylthiophenyl, Fluorphenyl, Chlorphenyl, Bromphenyl, Dibromphenyl, Chlortolyl, Methoxyxylyl oder Dichlortolyl. Bevorzugt ist Ar Phenyl oder durch $C_1$—$C_4$-Alkyl, Alkoxy, Phenoxy, Alkylthio, Phenylthio oder Halogen mono- oder disubstituiertes Phenyl.

$R^1$ und $R^2$ können zum Beispiel Hydroxyäthyl, Hydroxymethyl, Methoxyäthyl, Acetoxyäthyl, Dimethylaminomethyl, . Aethoxycarbonylmethyl, Methoxycarbonyläthyl, Cyanäthyl, Allyl, Methallyl, Cyclopentyl, Cyclohexyl oder Benzyl sein, bevorzugt sind $R^1$ und $R^2$ Alkyl, insbesondere $C_1$—$C_5$-Alkyl wie Methyl, Aethyl, Propyl, Butyl, Isobutyl, Pentyl oder Isopentyl.

$R^1$ und $R^2$ können zusammen Alkylen oder Oxa- oder Azaalkylen darstellen wie zum Beispiel Aethylen, Trimethylen, Tetramethylen, Pentamethylen, 3-Oxapentamethylen oder 3-Azapentamethylen.

Bevorzugt sind $R^1$ und $R^2$ Methyl, Tetramethylen oder Pentamethylen.

$R^3$ kann eine verzweigte oder unverzweigte Alkylengruppe sein, wie z.B. Methylen, 1,2-Aethylen, 1,2-Propylen, 1,3-Propylen, 1,4-Butylen, 1,6-Hexylen oder 1,8-Octylen.

Der Substituent X kann eine tertiäre Aminogruppe sein, wie z.B. eine Dialkylaminogruppe oder eine cyclische Aminogruppe. Beispiele hierfür sind die Dimethylamino-, Dibutylamino-, Methylhexylamino-, Diäthanolamino-, Di(äthoxyäthyl)amino-, Piperidino-, Morpholino- oder 4-Methylpiperazinogruppe.

Der Substituent X kann eine Hydroxylgruppe oder eine Aethergruppe sein. Der Aetherrest $R^6$ kann aliphatisch, cycloaliphatisch, araliphatisch, aromatisch oder heterocyclisch sein.

Der Substituent X kann eine Silyloxygruppe sein, beispielsweise Trimethyl-, Triphenyl-, Dimethylphenyl- oder Diphenylmethyl-siloxy.

Bevorzugt ist X eine Hydroxyl- oder Siloxygruppe, besonders bevorzugt eine Hydroxylgruppe.

Beispiele für Verbindungen der Formel I oder II sind:

2-Hydroxy-2-methyl-propiophenon
2-Hydroxy-2-methyl-(p-chlorpropiophenon)
2-Hydroxy-2-methyl-(p-methoxypropiophenon)
2-Hydroxy-2-methyl-(p-methylpropiophenon)
2-Hydroxy-2-methyl-(p-isopropylpropiophenon)
2-Hydroxy-2-methyl-(p-phenoxypropiophenon)
2-Methoxy-2-methyl-(p-fluorpropiophenon)
2-(2-Cyanäthoxy)-2-methyl-propiophenon
2-(2-Chloräthoxy)-2-methyl-(p-brompropiophenon)
2-(2-Methoxyäthoxy)-2-methyl-(p-phenyl-propiophenon)
2-(2-Hydroxyäthoxy)-2-äthyl-(p-phenylthio-propiophenon)
2-(2-Acetoxyäthoxy)-2-propyl-propiophenon
2-(2-Butylthiomethoxy)-2-methyl-propiophenon
2-Allyloxy-2-methyl-propiophenon
2-Cyclohexyloxy-2-methyl-propiophenon
1,4-Di($\alpha$-methyl-$\alpha$-benzyloxypropionyl)-benzol
4,4'-Di($\alpha$-methyl-$\alpha$-phenoxypropionyl)-diphenylmethan
2-($\alpha$-Hydroxy-$\alpha$-methylpropionyl)-tetrahydronaphthalin
2-($\alpha$-Isopropoxy-$\alpha$-methylpropanyl)-indan
2-Dimethylamino-2-methyl-propiophenon
2-(4-Cyanoäthyl-piperazino)-2-methyl-propiophenon
2-(Morpholino)-2-methyl-(p-phenyl-propiophenon)
2-Trimethylsiloxy-2-methyl-(p-chlorpropiophenon)
2-Triphenylsiloxy-2-allyl-propiophenon
1-Cyclohexyl-1-(p-chlorbenzoyl)-äthanol
2-Hydroxy-2-(hydroxymethyl)-propiophenon
2-Hydroxy-2,2-di(hydroxymethyl)-acetophenon
2-Hydroxy-2,2-di(2-cyanäthyl)-acetophenon
2-Methoxy-2,2-di(methoxymethyl)-acetophenon
2-Trimethylsiloxy-2,2-dibenzyl-acetophenon
1,4-Di-($\alpha$-hydroxyisobutyroyl)-benzol
2-Dimethylamino-2,2-di(2-äthoxycarbonyläthyl)-acetophenon
1,4-Dibenzoyl-1,4-dihydroxycyclohexan
4,4'-Bis-(1-hydroxy-1-benzoyl-äthyl)-diphenyl
2,3-Dihydroxy-2,3-dibenzoylbutan
2-Hydroxy-2-methyl-(p-methylthio-propiophenon)
2-Hydroxy-2-äthyl-caprophenon
1-Benzoyl-cyclohexanol
1-(4-Chlorbenzoyl)-cyclopentanol
2-Hydroxy-2-äthyl-butyrophenon
2-Hydroxy-2-methyl-butyrophenon
2,5-Dibenzoyl-2,5-dihydroxyhexan

In bestimmten Fällen kann es von Vorteil sein, ein Gemisch von 2 oder mehr Verbindungen der Formel I oder II als Photoinitiator zu verwenden, beispielsweise zur Verbesserung der Löslichkeit.

Die Menge der Photoinitiatoren in der photohärtbaren Zusammensetzung beträgt 0,1 bis 10 Gew.-% Geschieht die Photohärtung unter Sauerstoffausschluss, beispielsweise unter Stickstoff, so genügen etwa 0,1—1 Gew.-%; arbeitet man unter Luft, so benötigt man etwa 2—5 Gew.-%.

Die erfindungsgemäss als Lichtschutzmittel der Komponente (c) verwendeten Polyalkylpiperidinderivate sind monomere, oligomere oder polymere Verbindungen, die einen Rest der Formel

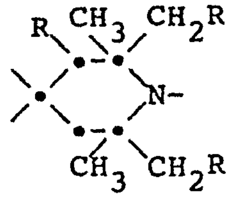

enthalten, worin R Wasserstoff oder Methyl ist, vorzugsweise jedoch Wasserstoff ist. Solche Verbindungen sind bekannte Lichtschutzmittel, insbesondere die 4-Acyloxypiperidinderivate wie sie beispielsweise in den DE—SO 1 929 928 und 2 258 752 beschrieben sind und die 4-Aminopiperidinderivate, wie sie z.B. in den DE—OS 2 040 975 und 2 349 962 beschrieben sind. Diese Piperidin-Lichtschutzmittel können auch ungesättigte Gruppen enthalten, die photopolymerisierbar sind wie z.B. 4-Acryloxypiperidine, 4-Acrylamidopiperidine oder 1-(Meth)acryloylpiperidine. In diesem Falle kann bei der Photohärtung eine Copolymerisation des Lichtschutzmittels mit der Komponente (a) eintreten. Ein solcherart einpolymerisiertes Lichtschutzmittel hat den Vorteil, dass es nicht durch Extraktion oder Migration entfernbar ist, sodass seine Wirkung sehr lange anhält. Einen ähnlichen Effekt erreicht man auch durch Verwendung von oligomeren oder polymeren Piperidin-Lichtschutzmitteln wie sie z.B. in der DE—OS 27 19 131 oder in der EP—A 000 496 beschrieben sind. Weiterhin können die Piperidin-Lichtschutzmittel auch sterisch gehinderte Phenolgruppen enthalten, wodurch sie gleichzeitig als Antioxydans wirken. Solche Verbindungen sind beispielsweise in der DE—OS 24 56 864 oder 26 47 452 beschrieben.

Die Piperidin-Lichtschutzmittel können auch in Form ihrer Salze mit anorganischen oder organischen Säuren verwendet werden sowie in Form ihrer Komplexe mit Nickelverbindungen, wie sie in der DE—OS 26 25 967 und in der EP—A 001 840 beschrieben sind.

In bestimmten Fällen kann der Zusatz der Piperidin-Lichtschutzmittel auch eine Beschleunigung der Photohärtung bewirken, was ein zusätzlicher Vorteil ist.

Beispiele für verwendbare Lichtschutzmittel aus der Klasse der Polyalkylpiperidinderivate sind:

4-Benzoyloxy-2,2,6,6-tetramethylpiperidin
4-Stearoyloxy-2,2,6,6-tetramethylpiperidin
4-Acryloxy-2,2,6,6-tetramethylpiperidin
4-(p-Chlorbenzoyloxy)-1,2,2,6,6-pentamethylpiperidin
4-Lauroyloxy-1,2,2,6,6-pentamethylpiperidin
4-Methacryloxy-1,2,2,6,6-pentamethylpiperidin
1-Allyl-2,2,6,6-tetramethyl-4-piperidinyl-salicylat
1-(2-Benzoyloxyäthyl)-2,2,6,6-tetramethyl-4-piperidinyl-benzoat
Bis-(1,2,2,6,6-pentamethyl-4-piperidinyl)-isophthalat
Bis-(1,2,2,6,6-pentamethyl-4-piperidinyl)-adipat
Bis-(2,2,6,6-tetramethyl-4-piperidinyl)-sebacat
Bis-(1-acetyl-2,2,6,6-tetramethyl-4-piperidinyl)-sebacat
Bis-(1-hydroxyäthyl-2,2,6,6-tetramethyl-4-piperidinyl)-succinat
Bis-(1-Benzyl-2,2,6,6-tetramethyl-4-piperidinyl)-sebacat
Bis-(1-Allyl-2,2,6,6-tetramethyl-4-piperidinyl)-adipat
Bis-(1,2,2,6,6-pentamethyl-4-piperidinyl)-sebacat
Tris-(2,2,6,6-tetramethyl-4-piperidinyl)-nitrilotriacetat
Tris-(1-butyl-2,2,6,6-tetramethyl-4-piperidinyl)-trimellithat
Tris-(1-butyl-2,2,6,6-tetramethyl-4-piperidinyl)-phosphat
Diphenyl-bis-(2,2,6,6-tetramethylpiperidin-4-oxy)-silan
Dibutylmalonsäure-di(1,2,2,6,6-pentamethyl-4-piperidinyl)-ester
Butyl-(3,5-di-tert.-butyl-4-hydroxybenzyl)-malonsäure-di-(2,2,6,6-tetramethyl-4-piperidinyl)-ester
O,O'-Di(2,2,6,6-tetramethyl-4-piperidinyl)-tolylen-1,4-dicarbamat
1-Methylcarbamoyl-2,3,6-trimethyl-2,6-diäthyl-4-piperidinyl-methylcarbamat
4-Acetylamino-1,2,2,6,6-pentamethylpiperidin
N,N'-Bis-(2,2,6,6-tetramethyl-4-piperidinyl)-hexamethylen-1,6-diamin
N,N'-Bis-(2,2,6,6-tetramethyl-4-piperidinyl)-N,N'-dibutyladipamid
1-Benzyl-2,2,6,6-tetramethyl-4-diäthanolamino-piperidin
4-Acrylamido-1,2,2,6,6-pentamethylpiperidin
9-Aza-8,8,10,10-tetramethyl-1,5-dioxaspiro[5.5]undecan
9-Aza-3-äthyl-3-acetoxymethyl-9-acetyl-8,8,10,10-tetramethyl-1,5-dioxaspiro[5.5]undecan
1,3,8-Triaza-3,7,7,9,9-pentamethylspiro[4.5]decan-2,4-dion
3-n-Octyl-1,3,8-triaza-7,7,9,9-tetramethylspiro[4.5]decan-2,4-dion
2,2,4,4-Tetramethyl-7-oxa-3,20-diaza-21-oxo-dispiro[5.1.11.2]heneicosan
1,3-Di(2,2,6,6-tetramethyl-4-piperidinyl)-imidazolidinon-2
2,4-Diphenoxy-6-(2,2,6,6-tetramethyl-4-piperidinoxy)-s-triazin
2,4,6-Tri[N-(2,2,6,6-tetramethyl-4-piperidinyl)-butylamino]-s-triazin
2-Dibutylamino-4,6-di[N-(1,2,2,6,6-pentamethyl-4-piperidinyl)-äthylamino]-s-triazin
1,4-Bis-(2,2,6,6-tetramethyl-1-piperidino)-buten-2
Di-[2-(2,2,6,6-tetramethyl-1-piperidino)-äthyl]-adipat
2,2,6,6-Tetramethylpiperidin-1-essigsäure-n-octylester
Polyester aus Bernsteinsäure, Adipinsäure, Sebacinsäure, Dibutylmalonsäure, Oxalsäure oder Isophthalsäure und 1-Hydroxyäthyl-2,2,6,6-tetramethyl-4-hydroxypiperidin
Polyamid aus Bernsteinsäure, Adipinsäure oder Phthalsäure und 1-(3-Aminopropyl)-2,2,6,6-tetramethyl-4-aminopiperidin

Polyamid aus Oxalsäure oder p-Phenylendiessigsäure und N,N'-Di-(1,2,2,6,6-pentamethyl-4-piperidinyl)-1,6-diaminohexan
Tetrakis-(2,2,6,6-tetramethyl-4-piperidinyl)-1,8,11,18-tetra-aza-octadecan
Polyamin aus 1,2,2,6,6-Pentamethyl-4-aminopiperidin und Epichlorhydrin oder Bisphenol-A-diglycidäther
Polytriazin aus 2,4-Dichlor-6-N-(1,2,2,6,6-pentamethyl-4-piperidinyl)-äthylamino-s-triazin und N,N'-Bis(2,2,6,6-tetramethyl-4-piperidinyl)-1,6-diaminohexan
Polytriazin aus 2,4-Dichlor-6-(1,1,3,3-tetramethyl-butylamino)-s-triazin und N,N'-Bis(2,2,6,6-tetramethyl-4-piperidinyl)-1,6-diaminohexan
Polymerisat aus 1,2,2,6,6-Pentamethyl-4-methacryloxypiperidin
Copolymerisat aus 1-Benzyl-2,2,6,6-tetramethyl-4-acrylamidopiperidin und N-Butylacrylamid
Salz aus 1 Mol $H_3PO_4$ und 1 Mol Adipinsäure-di-(1,2,2,6,6-pentamethyl-4-piperidinyl)-ester
Salz aus 2 Mol Bis-(3,5-di-tert.-butyl-4-hydroxybenzyl)-malonsäure und 1 Mol 2,2,6,6-Tetramethyl-4-lauroyloxypiperidin
1:1-Komplex von Bis-(2,2,6,6-tetramethyl-4-piperidinyl)-sebacat und Nickel-II-acetylacetonat
1:2-Komplex von Bis-(1,2,2,6,6-pentamethyl-4-piperidinyl)-adipat und Nickel-II-acetat

Weitere Beispiele für erfindungsgemäss verwendbare Piperidin-Lichtschutzmittel sind in der EP—A 002.753 beschrieben.

In bestimmten Fällen kann es von Vorteil sein, ein Gemisch von 2 oder mehr Lichtschutzmitteln aus der Reihe der Polyalkylpiperidinderivate zu verwenden. Die Menge an Lichtschutzmittel in der photohärtbaren Zusammensetzung beträgt 0,02 bis 5 Gew.-%, vorzugsweise 0,5 bis 2 Gew.-% und hängt vom gewünschten Grad der Stabilisierung ab.

Als Komponente (d) können die Zusammensetzungen weitere Additive enthalten wie sie in Kunststoffechnologie gie und insbesondere wie sie in der Technologie von photohärtbaren Ueberzügen üblich sind. Beispiele hierfür sind Stabilisatoren zur Erhöhung der Dunkellagerstabilität, Kettenübertragungsmittel, Farbstoffe, Pigmente, Paraffine oder Wachse, Stabilisatoren zur Erhöhung der thermischen Stabilität, Antioxydantien oder Verlaufshilfsmittel. Pigmente können in den Zusammensetzungen in Mengen bis zu 50% vorliegen. Die übrigen Zusätze werden hingegen nur in kleinen Mengen verwendet.

Das Mischen der Komponenten geschieht nach den üblichen Methoden. Bevorzugt wird als Komponente (a) eine flüssige Verbindung bzw. Gemisch verwendet. In diesem Falle können (b), (c) und gegebenenfalls (d) in die Komponente (a) durch Rühren eingemischt werden. Hierbei kann eine homogene Lösung resultieren oder eine Dispersion. In beiden Fällen entsteht eine Zusammensetzung, die sich nach den üblichen Methoden der Beschichtungstechnik auf feste Oberflächen aufbringen lässt, beispielsweise durch Streichen, Tauchen, Besprühen oder Walzen. Als Substrat kommen jede Art von festen Materialien in Frage wie z.B. Metall, Holz, Kunststoffe, Glas, Keramik, Papier, Textilien. Von besonderer Bedeutung ist die Beschichtung von Holz, z.B. für Möbel, Fussböden oder Wandelemente, die Beschichtung von Dekorationsplatten, beispielsweise bedruckten Papp-, Kunststoff- oder Holzfaserplatten, und die Beschichtung von Kunststoffen wie z.B. von Fussbodenbelägen oder von Möbelfolien. Die erfindungsgemässen Zusammensetzungen eignen sich auch zur Herstellung licht-beständiger Formmassen, vor allem von transparenten Formmassen, beispielsweise von Platten aus Acrylgas oder ungesättigten Polyestern.

Die Polymerisation des aufgetragenen Ueberzuges bzw. der Formmasse erfolgt nach den bekannten Methoden der Photopolymerisation durch Bestrahlung mit Licht, das reich an kurzwelliger Strahlung ist. Als Lichtquellen sind z.B. Quecksilbermitteldruck-, -hochdruck- und -niederdruckstrahler, sowie superaktinische Leuchtstoffröhren, geeignet, deren Emissionsmaxima im Bereich zwischen 250 und 400 nm liegen.

Die nötige Belichtungszeit muss für jede Zusammensetzung bei der jeweiligen Schichtdicke und Art der Strahlenquelle experimentell ermittelt werden. Für dünne Schichten liegt die Belichtungszeit — je nach Strahlenquelle — bei etwa 0,1 bis 10 Sekunden. Als Mass der Härtung kann zunächst die Wischfestigkeit der Oberfläche beurteilt werden. Ein exakteres Mass, das auch ein Bild über die Durchhärtung gibt, ist die Messung der Pendelhärte nach König (DIN 33 157). Der Härtungsgrad von Formmassen kann durch Messung der Barcol-Härte oder oder Shore-D-Härte beurteilt werden.

Die Vergilbung der Ueberzüge und Formmassen kann durch spektroskopische Messung des Yellowness Index (YI) nach ASTM—D 1925/63 T oder des Transmissionsverlustes bei 400 nm gemessen werden.

Die folgenden Beispiele zeigen die Anwendung von erfindungsgemässen Zusammensetzungen im Vergleich mit dem Stand der Technik. Hierin bedeuten Teile Gewichtsteile, Prozente Gewichtsprozente, soweit nichts anderes angegeben. Die Temperatur ist in Celsiusgraden angegeben.

## Beispiel 1

Die folgenden Versuche zeigen die Vergilbung von photopolymerisierten transparenten Ueberzügen. Verwendet wurden Zusammensetzungen der folgenden *Grundrezeptur*:

70 Teile EBECRYL® 204 (Polyurethanacrylat auf Basis Tolylendiisocyanat der Fa. UCB. Brüssel)
27 Teile 1,6-Hexandioldiacrylat
3 Teile Photoinitiator

Wie in Tabelle 1 angegeben wurden hierzu 0 oder 1 oder 2 Teile der folgenden Piperidin-Lichtschutzmittel zugemischt:

LS I = Bis-(2,2,6,6-tetramethyl-4-piperidinyl)-sebacat
LS II = 1,2,2,6,6-Pentamethyl-4-methacryloxypiperidin
LS III = Butyl-(3,5-di-tert.-butyl-4-hydroxybenzyl)-malonsäure-di-(1,2,2,6,6-pentamethyl-4-piperidinyl)-ester

Als Photoinitiatoren wurden verwendet:

A = $\alpha$-Hydroxy-p-isopropyl-isobutyrophenon (erfindungsgemäss)
B = Benzil-dimethylketal (als Vergleich)
C = $\alpha$-Diäthoxy-acetophenon (als Vergleich)

Die Mischungen wurden in einer Schichtdicke von 70—80 $\mu$ auf weiss gestrichene Aluminiumbleche aufgetragen und in einem HANOVIA-Laborgerät 1,5 Sekunden belichtet. Die Proben wurden 1 Woche im Dunkeln gelagert und anschliessend 720 Stunden in einem XENOTEST 150 belichtet. Tabelle 1 zeigt den Yellowness-Index gemäss ASTM—D 1925/63 T unmittelbar nach der Photohärtung, nach 24 Stunden Dunkellagerung sowie nach verschiedenen Belichtungszeiten im Xenotest.

Daraus ist zu ersehen, dass ganz allgemein der Zusatz der Piperidin-Lichtschutzmittel eine gewisse Vergilbung bewirkt. Bei der Belichtung im Xenotest tritt bei den Proben ohne Lichtschutzmittel ein starker Anstieg der Vergilbung ein. Dieser kann im Falle des Initiators A durch den Zusatz der Piperidinlichtschutzmittel reduziert werden, im Vergleich B tritt keine Reduktion der Vergilbung ein.

TABELLE 1

| Photo-initiator | Lichtschutz-mittel | Yellowness — Index nach | | | | |
|---|---|---|---|---|---|---|
| | | UV-Härtung | 1 Woche Dunkel-lagerung | Bestrahlung im Xenotest 150 | | |
| | | | | Std. 24 | Std. 216 | Std. 720 |
| A | – | 2,1 | 1,4 | 5,7 | 8,1 | 14,8 |
| | 1% LS I | 4,6 | 4,1 | 7,0 | 9,3 | 12,7 |
| | 2% LS I | 3,0 | 3,2 | 3,7 | 6,3 | 10,7 |
| | 1% LS II | 2,6 | 3,2 | 4,6 | 5,1 | 8,2 |
| | 2% LS II | 2,9 | 2,3 | 3,6 | 5,9 | 10,1 |
| | 1% LS III | 1,9 | 1,7 | 5,0 | 6,4 | 11,0 |
| B | – | 5,4 | 3,2 | 11,5 | 12,3 | 18,2 |
| (Vergleich) | 1% LS I | 7,8 | 3,5 | 11,4 | 13,3 | 17,6 |
| | 2% LS I | 6,3 | 4,3 | 12,0 | 15,2 | 19,8 |
| C | – | 2,3 | 4,2 | 5,3 | 5,8 | 10,2 |
| (Vergleich) | 1% LS I | 3,4 | 12,3 | 3,7 | 6,0 | 9,6 |
| | 2% LS I | 6,7 | 15,2 | 5,3 | 7,3 | 12,1 |
| | 1% LS II | 3,0 | 7,4 | 5,7 | 6,8 | 10,8 |
| | 1% LS III | 2,4 | 4,2 | 4,4 | 5,6 | 9,1 |

## Beispiel 2

Die folgenden Versuche zeigen den Einfluss der verwendeten Lichtschutzmittel auf die Geschwindigkeit der Photopolymerisation, gemessen an der Pendelhärte des polymerisierten Filmes nach einer bestimmten Belichtungszeit.

Die verwendete Grundrezeptur ist dieselbe wie in Beispiel 1. Als Photoinitiator wurde α-Hydroxyisobutyrophenon verwendet.

Als Lichtschutzmittel wurden verwendet:

Erfindungsgemässe Piperidinderivate:

LS I = Bis-(2,2,6,6-tetramethyl-4-piperidinyl)-sebacat
LS IV = Bis-(1,2,2,6,6-pentamethyl-4-piperidinyl)-sebacat.

UV-Absorber als Vergleich:

UV I = 2-Hydroxy-4-dodecyloxy-benzophenon
UV II = 2-[2'-Hydroxy-3',5'-di-tert.amyl-phenyl]benztriazol.

Die Versuche wurden wie in Beispiel 1 beschrieben durchgeführt. Nach der Belichtung im HANOVIA-Gerät wurden die Proben 30 Minuten gelagert und dann die Pendelhärte gemessen.

TABELLE 2

| Gew.–% Lichtschutzmittel | Pendelhärte nach König (Sekunden) nach 1,5 Sek. Belichtungszeit |
|---|---|
| 0 | 57 |
| 1% LS I | 54 |
| 1% LS IV | 55 |
| 1% UV I | 26 |
| 1% UV II | <10 |

## Beispiel 3

Die folgende Versuchsreihe zeigt den Einfluss der Lichtschutzmittel auf die Vergilbung eines Acrylharzes vor und nach Belichtung mit einem Xenotest-Gerät.

Grundrezeptur:

67,6 Teile Ebecryl® 210 (Urethanacrylat-Präpolymer der Fa. UCB, Brüssel)
9,8 Teile Butandiol-1,4-diacrylat
19,6 Teile N-Vinylpyrrolidon
3 Teile Photoinitiator
———
100 Teile

Verwendete Photoinitiatoren:

D α-Hydroxyisobutyrophenon
E 1-Benzoyl-cyclohexanol
F α-Hydroxy-p-chlor-isobutyrophenon
G α-(Trimethylsiloxy)-isobutyrophenon

In diese Grundrezeptur wurden jeweils 0,1%, 0,5% und 1% der in Beispiel 1 beschriebenen Lichtschutzmittel

LS I und LS III sowie
LS V = 1,2,2,6,6-Pentamethyl-4-acryloxypiperidin eingemischt.

Zwischen zweit Glasplättchen (4 x 4 cm) wurde ein 0,5 mm starker Gummiring als Abstandshalter gelegt und der Raum innerhalb des Gummiringes mit dem flüssigen Acrylatharz ausgegossen. Diese Proben wurden durch 30 Minuten Bestrahlung mit 2 superaktinischen Leuchtstoffröhren (Philips TL 05/20) im Abstand von 20 cm ausgehärtet.

Nach Messung des Yellowness-Index wurden die Proben im Xenotest 150 jeweils 24, 48, 76 und 500 Stunden belichtet und die dabei eingetretene Vergilbung durch Messung des Yellowness-Index bestimmt. Je höher der Yellowness-Index desto stärker ist die Vergilbung.

TABELLE 3

| Photo-initiator | Lichtschutz-mittel | Yellowness – Index nach | | | | |
|---|---|---|---|---|---|---|
| | | 0 | 24 | 48 | 76 | 500 Std. |
| D | – | 4 | 11 | 13 | 15 | 21 |
| | 0,1% LS I | 4 | 10 | 11 | 12 | 19 |
| | 0,5% LS I | 4 | 9 | 11 | 12 | 19 |
| | 1% LS I | 4 | 9 | 11 | 12 | 21 |
| E | – | 3 | 19 | 22 | 25 | 31 |
| | 0,1% LS I | 3 | 7 | 8 | 9 | 15 |
| | 0,5% LS I | 3 | 7 | 8 | 9 | 16 |
| | 1% LS I | 3 | 8 | 9 | 10 | 18 |
| F | – | 3 | 31 | 36 | 40 | 49 |
| | 0,1% LS I | 3 | 28 | 31 | 33 | 48 |
| | 0,5% LS I | 3 | 19 | 21 | 24 | 35 |
| | 1% LS I | 4 | 19 | 21 | 19 | 24 |
| G | – | 3 | 10 | 12 | 15 | 22 |
| | 0,1% LS I | 3 | 7 | 7 | 8 | 17 |
| | 0,5% LS I | 4 | 7 | 8 | 9 | 18 |
| | 1% LS I | 4 | 7 | 8 | 9 | 22 |

TABELLE 4

| Photo-initiator | Lichtschutz-mittel | Yellowness – Index nach | | | | |
|---|---|---|---|---|---|---|
| | | 0 | 24 | 48 | 76 | 500 Std. |
| D | – | 3 | 11 | 13 | 15 | 21 |
| | 0,1% LS III | 3 | 10 | 10 | 11 | 17 |
| | 0,5% LS III | 3 | 10 | 10 | 11 | 17 |
| | 1% LS III | 3 | 8 | 10 | 10 | 13 |
| E | – | 3 | 19 | 22 | 25 | 31 |
| | 0,1% LS III | 3 | 9 | 10 | 13 | 20 |
| | 0,5% LS III | 3 | 8 | 9 | 10 | 15 |
| | 1% LS III | 3 | 7 | 8 | 9 | 15 |
| F | – | 3 | 31 | 36 | 40 | 49 |
| | 0,1% LS III | 2 | 29 | 32 | 33 | 46 |
| | 0,5% LS III | 3 | 22 | 25 | 27 | 38 |
| | 1% LS III | 3 | 23 | 25 | 27 | 38 |
| G | – | 3 | 10 | 12 | 15 | 22 |
| | 0,1% LS III | 4 | 8 | 8 | 9 | 16 |
| | 0,5% LS III | 4 | 9 | 9 | 10 | 18 |
| | 1% LS III | 4 | 9 | 9 | 10 | 18 |

TABELLE 5

| Photo-initiator | Lichtschutz-mittel | Yellowness – Index nach | | | | |
|---|---|---|---|---|---|---|
| | | 0 | 24 | 48 | 76 | 500 Std. |
| D | – | 3 | 11 | 13 | 15 | 21 |
| | 0,1% LS V | 3 | 10 | 12 | 13 | 18 |
| | 0,5% LS V | 3 | 9 | 11 | 12 | 17 |
| | 1% LS V | 3 | 9 | 11 | 11 | 16 |
| E | – | 3 | 19 | 22 | 25 | 31 |
| | 0,1% LS V | 3 | 7 | 8 | 9 | 16 |
| | 0,5% LS V | 3 | 8 | 8 | 9 | 16 |
| | 1% LS V | 3 | 8 | 8 | 9 | 14 |
| F | – | 3 | 31 | 36 | 40 | 49 |
| | 0,1% LS V | 3 | 22 | 25 | 27 | 39 |
| | 0,5% LS V | 3 | 18 | 22 | 24 | 37 |
| | 1% LS V | 3 | 18 | 19 | 19 | 22 |
| G | – | 3 | 10 | 12 | 15 | 22 |
| | 0,1% LS V | 3 | 7 | 7 | 8 | 16 |
| | 0,5% LS V | 3 | 7 | 7 | 8 | 16 |
| | 1% LS V | 3 | 6 | 7 | 8 | 16 |

## Patentansprüche

1. Photohärtbare Zusammensetzung, bestehend aus
(a) einer oder mehreren äthylenisch ungesättigten, photohärtbaren Verbindungen,
(b) 0,1 bis 10 Gew.% mindestens eines Photoinitiators der Formel I oder II,

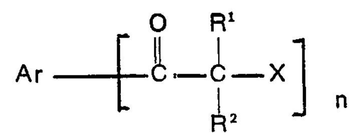

I

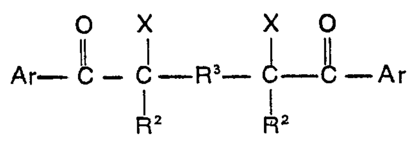

II

worin

n 1 oder 2 ist,

Ar, wenn n=1 ist, unsubstituiertes oder durch einen oder mehrere des Reste F, Cl, Br, $C_1$—$C_{12}$ Alkyl, -OAlk, Phenyl, -OPhenyl, —SAlk, —$SCH_2CH_2OH$ oder -SPhenyl, substituiertes Phenyl, Indanyl oder Tetrahydronaphthyl darstellt und Alk einen Niederalkylrest mit 1—4 C-Atomen bedeutet und wenn n=2, $C_6$—$C_{12}$ Arylen oder eine Gruppe -Phenylen-T-Phenylen- bedeutet, worin T —O—, —S—, —$CH_2$— oder —$CH_2CH_2$— darstellt,

X eine der Gruppen —$NR^4R^5$, —$OR^6$ oder —$OSiR^7$ $(R^8)_2$ darstellt,

$R^1$ unsubstituiertes oder durch —OH, OAlk, $C_2$—$C_8$ Acyloxy, —$NR^4R^5$, —COOAlk oder —CN substituiertes $C_1$—$C_8$ Alkyl, $C_3$—$C_4$ Alkenyl, $C_5$—$C_6$ Cycloalkyl oder $C_7$—$C_9$ Phenylalkyl bedeutet,

$R^2$ eine der für $R^1$ gegebenen Bedeutungen hat oder zusammen mit $R^1$ $C_2$—$C_8$ Alkylen oder $C_3$—$C_9$ Oxa- oder Azaalkylen bedeutet,

$R^3$ eine direkte Bindung, $C_1$—$C_6$ Alkylen, $C_2$—$C_6$ Oxaalkylen, $C_2$—$C_6$ Thia-, S-Oxothia- oder S-Dioxothiaalkylen, Phenylen, Diphenylen oder eine Gruppe -Phenylen-T-Phenylen bedeutet oder zusammen mit den beiden Substituenten $R^2$ und den beiden C-Atomen, an die diese Substituenten gebunden sind, einen Cyclopentan-Cyclohexen-, Endomethylencyclohexan oder Cyclohexanring bildet,

$R^4$ $C_1$—$C_{12}$ Alkyl oder durch —OH oder OAlk substituiertes $C_2$—$C_4$ Alkyl bedeutet,

$R^5$ $C_1$—$C_{12}$ Alkyl oder durch OH oder OAlk substituiertes $C_2$—$C_4$ Alkyl, bedeutet oder zusammen mit $R^4$ $C_4$—$C_5$ Alkylen bedeutet, das durch —O— oder —$NR^9$— unterbrochen sein kann, ,

$R^6$ Wasserstoff, $C_1$—$C_{12}$ Alkyl, durch Cl, Br, OH, OAlk, SAlk, $C_2$—$C_8$ Acyloxy, —COOAlk, —CONHAlk, —CON(Alk)$_2$ oder CN substituiertes $C_1$—$C_8$ Alkyl, $C_3$—$C_5$ Alkenyl, Cyclohexyl, Benzyl, unsubstituiertes oder durch Cl oder Alk substituiertes Phenyl oder 2-Tetrahydropyranyl bedeutet,

$R^7$ und $R^8$ gleich oder verschieden sind und $C_1$—$C_4$ Alkyl oder Phenyl bedeuten, und

$R^9$ $C_1$—$C_4$ Alkyl, —$CH_2CH_2CN$ oder —$CH_2CH_2COOAlk$ bedeuten,

c) 0,02 bis 5 Gew.% eine Lichtschutzmittels aus der Klasse der Polyalkylpiperidinderivate enthaltend einen Rest der Formel

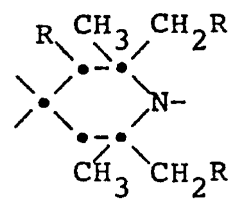

worin

R Wasserstoff oder Methyl ist, und

d) gegebenenfalls einem oder mehreren sonstigen in der Kunststofftechnologie üblichen Additiven.

2. Zusammensetzung gemäss Anspruch 1, dadurch gekennzeichnet, dass die Komponente (b) ein Photohärter der Formel I oder II, ist, worin n 1 oder 2 ist X —$OR^6$ oder —$OSiR^7$ $(R^8)_2$ darstellt und Ar, $R^1$, $R^2$, $R^3$, $R^6$, $R^7$ und $R^8$ die in Anspruch 1 gegebene Bedeutung haben.

3. Zusammensetzung gemäss Anspruch 1, dadurch gekennzeichnet, dass die Komponente (b) ein Photohärter der Formel I oder II ist, worin $n = 1$ ist, X eine Hydroxylgruppe ist, Ar einen unsubstituierten oder durch $C_1$—$C_4$-Alkyl, $C_1$—$C_4$-Alkoxy, Phenoxy, $C_1$—$C_4$-Alkylthio, Phenylthio oder Halogen mono- oder disubstituierten Phenylrest darstellt, $R^1$ und $R^2$ unabhängig voneinander $C_1$—$C_5$-Alkyl oder $R^1$ und $R^2$ zusammen Tetra- oder Pentamethylen darstellen und $R^3$ eine direkte Bindung oder $C_1$—$C_8$-Alkylen darstellt.

4. Zusammensetzung gemäss Anspruch 1, bestehend aus (a) einer oder mehreren photopolymerisierbaren. Verbindungen aus der Reihe der Acryl- und Methacrylsäurederivate, (b) einem Photoinitiator der Formel I, worin $n = 1$, X —OH oder —$OSi(CH_3)_3$ ist, Ar Phenyl, Alkylphenyl, Alkoxyphenyl oder Chlorphenyl ist und $R^1$ und $R^2$ Methyl oder $R^1$ und $R^2$ zusammen Tetra- oder Pentamethylen sind, (c) einem Lichtschutzmittel aus der Klasse der Polyalkylpiperidine und (d) gegebenenfalls einem oder mehreren sonstigen in der Technologie photohärtbarer Massen üblichen Additiven.

5. Zusammensetzung gemäss Anspruch 4, dadurch gekennzeichnet, dass das Lichtschutzmittel (c) ein Acryl- oder Methacrylsäurederivat eines Polyalkylpiperidins ist.

6. Zusammensetzung gemäss Anspruch 4, dadurch gekennzeichnet, dass die Komponente (a) ein Polyurethanacrylat oder dessen Gemisch mit anderen Acryl- oder Methacrylsäurederivaten ist.

**Revendications**

1. Composition photodurcissable constituée:

(a) d'un ou plusieurs composés éthyléniques photodurcissables,

(b) de 0,1 à 10% en poids d'au moins un photo-amorceur répondant à l'une des formules I et II

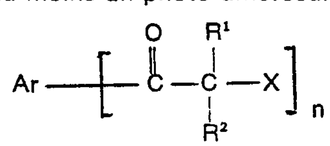
I

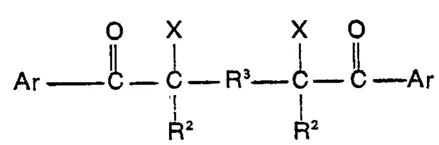
II

dans lesquelles

n est égal à 1 ou à 2,

Ar représente, lorsque n est égal à 1, un radical tétrahydronaphtyle, indanyle ou phényle non substitué ou porteur d'un ou plusieurs substituants pris dans l'ensemble constitué par F, Cl, Br et les radicaux alkyles en $C_1$—$C_{12}$, —OAlk ("Alk" étant un alkyle inférieur en $C_1$—$C_4$), phényle, phénoxy, —SAlk, —$SCH_2CH_2OH$ ou phénylthio, et, lorsque n est égal à 2, un arylène en $C_6$—$C_{12}$ ou un radical -phénylène-T-phénylène dans lequel T représente —O—, —S—, —$CH_2$— ou —$CH_2CH_2$—,

X représente un groupe —$NR^4R^5$, —$OR^6$ ou —$OSiR^7$ $(R^8)_2$,

$R^1$ représente un radical alkyle en $C_1$—$C_8$ non substitué ou porteur d'un radical —OH —OAlk, acyloxy en $C_2$—$C_8$, —$NR^4R^5$, —COOAlk ou —CN, un radical alcényle en $C_3$ ou $C_4$, cyclo-alkyle en $C_5$ ou $C_6$ ou phénylalkyle en $C_7$—$C_9$,

$R^2$ représente l'un des radicaux définis pour $R^1$ ou forme avec $R^1$ un radical alkylène en $C_2$—$C_8$ ou un radical oxa- ou aza-alkylène en $C_3$—$C_9$,

$R^3$ représente une liaison directe, un alkylène en $C_1$—$C_6$, un oxa-alkylène en $C_2$—$C_6$, un thia-, S-oxathia- ou S-dioxothia-alkylène en $C_2$—$C_6$, un phénylène, un biphénylylène ou un radical -phénylène -T-phénylène, ou forme, avec les deux substituants $R^2$ et les deux atomes de carbone qui portent ces substituants, un noyau de cyclopentane, de cyclohexène, d'endo-méthylène-cyclohexane ou de cyclohexane,

$R^4$ représente un alkyle en $C_1$—$C_{12}$ ou un alkyle en $C_2$—$C_4$ porteur d'un groupe —OH ou —OAlk,

$R^5$ représente un alkyle en $C_1$—$C_{12}$ ou un alkyle en $C_2$—$C_4$ porteur d'un —OH ou d'un —OAlk, ou forme, avec $R^4$, un alkylène en $C_4$ ou $C_5$ qui peut être interrompu par —O— ou —$NR^9$—,

$R^6$ représente l'hydrogène, un alkyle en $C_1$—$C_{12}$, un alkyle en $C_1$—$C_8$ porteur d'un Cl, d'un Br, d'un OH, d'un OAlk, d'un SAlk, d'un acyloxy en $C_2$—$C_8$, d'un —COOAlk, d'un —CONHAlk, d'un —$CON(Alk)_2$ ou d'un —CN, un alcényle en $C_3$—$C_5$, un cyclohexyle, un benzyle, un phényle non substitué ou porteur d'un Cl ou d'un Alk, ou un tétrahydropyrannyle-2,

$R^7$ et $R^8$ sont identiques ou différents et représentent chacun un alkyle en $C_1$—$C_4$ ou un phényle, et

$R^9$ représente un alkyle en $C_1$—$C_4$, un —$CH_2CH_2CN$ ou un —$CH_2CH_2COOAlk$,

c) de 0,02 à 5% en poids d'un stabilisant à la lumière de la catégorie des dérivés de polyalkyl-pipéridines contenant un radical répondant à la formule

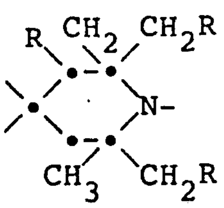

dans laquelle

R représente l'hydrogène ou le radical méthyle, et

d) éventuellement d'un ou plusieurs autres additifs couramment utilisés dans la technique des matières plastiques.

2. Composition selon la revendication 1, caractérisée en ce que la composante (b) est un photodurcisseur de formule I ou II dans lequel n est égal à 1 ou à 2, X représente un groupe —$OR^6$ ou —$OSiR^7$ $(R^8)_2$, et Ar, $R^1$, $R^2$, $R^3$, $R^6$, $R^7$ et $R^8$ ont les significations données à la revendication 1.

3. Composition selon la revendication 1, caractérisée en ce que la composante (b) est un photodurcisseur de formule I ou II dans lequel n est égal à 1, X représente un groupe hydroxy, Ar un radical phényle non substitué ou porteur d'un ou deux substituants pris dans l'ensemble constitué par les alkyles en $C_1$—$C_4$, les alcoxy en $C_1$—$C_4$, le phénoxy, les alkylthio en $C_1$—$C_4$, le phénylthio et les halogènes, $R^1$ et $R^2$ représentent chacun, indépendamment l'un de l'autre, un alkyle en $C_1$—$C_5$, ou $R^1$ et $R^2$ forment ensemble un radical tétraméthylène ou pentaméthylène, et $R^3$ représente une liaison directe ou un alkylène en $C_1$—$C_8$.

4. Composition selon la revendication 1, qui est constituée: (a) d'un ou plusieurs composés photopolymérisables de la série des composés acryliques et méthacryliques, (b) d'un photo-amorceur de formule I dans lequel n est égal à 1, X représente —OH ou —$OSiCH_3)_3$, Ar un radical phényle, alkylphényle, alcoxyphényle ou chloro-phényle, et $R^1$ et $R^2$ représentent chacun un radical méthyle ou forment ensemble un radical tétraméthylène ou pentaméthylène, (c) d'un stabilisant à la lumière de la catégorie des polyalkyl-pipéridines, et (d) éventuellement d'un ou plusieurs autres additifs couramment utilisés dans la technique des matières photodurcissables.

5. Composition selon la revendication 4, caractérisée en ce que le stabilisant à la lumière (c) est un composé dérivant de l'acide acrylique ou méthacrylique et d'une polyalkyl-pipéridine.

6. Composition selon la revendication 4, caractérisée en ce que la composant (a) est un polyuréthanne-acrylate ou un mélange d'un polyuréthanne-acrylate avec d'autres dérivés de l'acide acrylique ou de l'acide méthacrylique.

**Claims**

1. A photocurable composition consisting of
(a) one or more ethylenically unsaturated, photocurable compounds,
(b) 0.1 to 10% by weight of at least one photoinitiator of the formula I or II

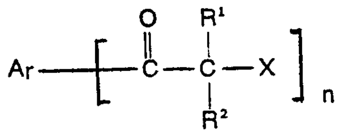

I

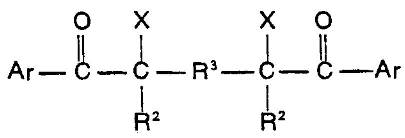

II

in which
n is 1 or 2, and, if n is 1,
Ar is unsubstituted phenyl or phenyl substituted by one or more of the radicals F, Cl, Br, $C_1$—$C_{12}$ alkyl, —OAlk, phenyl, -Ophenyl, —SAlk, —$SCH_2CH_2OH$ or -Sphenyl, or is indanyl or tetrahydronaphthyl, and Alk is a lower alkyl radical having 1—4 C atoms, and, if n is 2, Ar is $C_6$—$C_{12}$ arylene or a group -phenylene-T-phenylene-, in which T is —O—, —S—, —$CH_2$— or —$CH_2CH_2$,
X is one of the groups —$NR^4R^5$, —$OR^6$ or —$OSiR^7(R^8)_2$,
$R^1$ is unsubstituted $C_1$—$C_8$ alkyl or $C_1$—$C_8$ alkyl substituted by —OH, OAlk, $C_2$—$C_8$ acyloxy, —$NR^4R^5$, —COOAlk or —CN, or is $C_3$—$C_4$ alkenyl, $C_5$—$C_6$ cycloalkyl or $C_7$—$C_9$ phenylalkyl,
$R^2$ has one of the meanings defined for $R^1$ or, together with $R^1$, is $C_2$—$C_8$ alkylene or $C_3$—$C_9$ oxa- or aza-alkylene,
$R^3$ is a direct bond, $C_1$—$C_6$ alkylene, $C_2$—$C_6$ oxa-alkylene, $C_2$—$C_6$ thia-, S-oxothia- or S-dioxothia-alkylene, phenylene, diphenylene or a group -phenylene-T-phenylene-, or together with the two substituents $R^2$ and the two C atoms to which these substituents are attached, forms a cyclopentane, cyclohexane, endomethylenecyclohexane or cyclohexane ring,
$R^4$ is $C_1$—$C_{12}$ alkyl or $C_2$—$C_4$ alkyl which is substituted by —OH or OAlk,
$R^5$ is $C_1$—$C_{12}$ alkyl or $C_2$—$C_4$ alkyl which is substituted by OH or OAlk, or together with $R^4$ is $C_4$—$C_5$ alkylene, which can be interrupted by —O— or —$NR^9$—,
$R^6$ is hydrogen, $C_1$—$C_{12}$ alkyl, $C_1$—$C_8$ alkyl substituted by Cl, Br, OH, OAlk, SAlk, $C_2$—$C_8$ acyloxy, —COOAlk, —CONHAlk, —$CON(Alk)_2$ or CN, or is $C_3$—$C_5$ alkenyl, cyclohexyl, benzyl, unsubstituted phenyl or phenyl substituted by Cl or Alk, or is 2-tetrahydropyranyl,
$R^7$ and $R^8$ are identical or different and are $C_1$—$C_4$ alkyl or phenyl, and $R^9$ is $C_1$—$C_4$ alkyl, —$CH_2CH_2CN$ or —$CH_2CH_2COOAlk$,
(c) 0.02 to 5% by weight of at least one light stabiliser selected from the class of the polyalkylpiperidine derivatives containing a radical of the formula

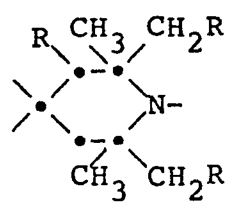

wherein
R is hydrogen or methyl, and
(d) optionally one or more other additives customarily employed in plastics technology.

2. A composition according to claim 1, wherein component (b) is a photocuring agent of the formula I or II in which n is 1 or 2, X is —$OR^6$ or —$OSiR^7(R^8)_2$ and Ar, $R^1$, $R^2$, $R^3$, $R^6$, $R^7$ and $R^8$ are as defined in claim 1.

3. A composition according to claim 1, wherein component (b) is a photocuring agent of the formula I or II in which n is 1, X is a hydroxyl group, Ar is an unsubstituted phenyl radical or a phenyl radical monosubstituted or disubstituted by $C_1$—$C_4$ alkyl, $C_1$—$C_4$ alkoxy, phenoxy, $C_1$—$C_4$ alkylthio, phenylthio or halogen, and $R^1$ and $R^2$ independently of each other are $C_1$—$C_5$ alkyl, or $R^1$ and $R^2$ together are tetramethylene or pentamethylene, and $R^3$ is a direct bond or $C_1$—$C_8$ alkylene.

4. A composition according to claim 1, consisting of (a) one or more photopolymerisable compounds of the series comprising the acrylic and methacrylic acid derivatives, (b) a photoinitiator of the formula I, in which n = 1, X is —OH or —$OSi(CH_3)_3$, Ar is phenyl, alkylphenyl, alkoxyphenyl or chlorophenyl and $R^1$ and $R^2$ are methyl, or $R^1$ and $R^2$ together are tetramethylene or pentamethylene, (c) a light stabiliser of the class of the polyalkylpiperidines and (d) optionally one or more other additives customarily employed in the technology of photocurable compositions.

5. A composition according to claim 4, wherein the light stabiliser (c) is an acrylic or methacrylic acid derivative of a polyalkylpiperidine.

6. A composition according to claim 4, wherein component (a) is a polyurethane acrylate or a mixture thereof with other acrylic or methacrylic acid derivatives.